Europäisches Patentamt

European Patent Office

Office européen des brevets

(11) Publication number: **0 157 783**
**B1**

## EUROPEAN PATENT SPECIFICATION

(45) Date of publication of patent specification: 20.12.89

(51) Int. Cl.⁴: **G 03 C 1/68,** G 03 C 1/71

(21) Application number: 84903021.8

(22) Date of filing: 23.07.84

(86) International application number:
PCT/US84/01188

(87) International publication number:
WO 85/00670 14.02.85 Gazette 85/04

(54) THERMAL DEVELOPMENT OF PHOTOSENSITIVE MATERIALS EMPLOYING MICROENCAPSULATED RADIATION SENSITIVE COMPOSITIONS.

(30) Priority: 25.07.83 US 517115

(43) Date of publication of application:
16.10.85 Bulletin 85/42

(45) Publication of the grant of the patent:
20.12.89 Bulletin 89/51

(84) Designated Contracting States:
BE DE FR GB SE

(56) References cited:
FR-A-2 516 269
GB-A- 799 479
GB-A-1 128 513
JP-A-57 124 343
US-A-3 072 481
US-A-3 576 660

(73) Proprietor: THE MEAD CORPORATION
Mead World Headquarters Courthouse Plaza Northeast
Dayton Ohio 45463 (US)

(72) Inventor: ADAIR, Paul, Clinton
1544 Professional Drive
Chillicothe, OH 45601 (US)
Inventor: McLAIN, Michael, Kenneth
2431 J Shore Boulevard, East
Columbus, OH 43227 (US)

(74) Representative: Deans, Michael John Percy et al
Lloyd Wise, Tregear & CO. Norman House
105-109 Strand
London WC2R OAE (GB)

Courier Press, Leamington Spa, England.

EP 0 157 783 B1

## Description

The present invention relates to a convenient means for developing photosensitive materials employing a microencapsulated radiation sensitive composition. More particularly it relates to imaging sheets and an imaging process utilising the application of heat following exposure. In one aspect it provides transfer imaging means.

Photosensitive materials employing microencapsulated radiation sensitive compositions are described in FR—A—2516269 of The Mead Corporation and in Japanese Laid-Open Applications 57-124343, 57-179836 and 57-197538 of Fuji Photo Film Co., Ltd. In a typical example of the aforementioned photosensitive materials, a colour precursor of the electron donor type is encapsulated with a radiation sensitive material and a layer of the microcapsules is coated on a support to provide an imaging sheet. The imaging sheet is image-wise exposed and then assembled with a developer sheet carrying a material which reacts with the colour precursor to produce a colour image. The microcapsules are pressure rupturable. Typically, the assembled sheets are passed together through the nip between two pressure rollers whereupon the microcapsules rupture and image-wise release the colour precursor which is transferred to the developer sheet where it reacts and forms an image. In a related embodiment, the developer may be carried on the imaging sheet in a layer underlying the layer of microcapsules. This sheet is exposed and passed through a pressure nip whereupon the microcapsules rupture and the color precursor migrates to the underlying developer layer where it reacts and forms an image.

The following patents describe other photosensitive imaging materials employing microcapsules:

Berman, U.S. Patent No. 3,219,446 discloses a transfer imaging process in which a blue-black dye is encapsulated with a photocrosslinkable polymer or a photopolymerizable monomer in a film or a layer of discrete microcapsules. In this system imaging is accomplished by image-wise exposing the layer of the encapsulated material to electromagnetic radiation to crosslink the polymer or polymerize the monomer. This is said to cause the liquid in the exposed microcapsules to assume a non-liquid, rigid condition, such that upon rupturing the microcapsules only the dye from the unexposed microcapsules is transferred to a receiving sheet where images are formed.

Phillips, U.S. Patent No. 3,700,439, discloses a process wherein Michler's ketone is encapsulated in a conventional manner and provided as a layer on a support. Michler's ketone is not a color former, but irradiation of the ketone converts it to a colorless, acid colorable, dye precursor. Thus, by image-wise exposing the Phillips material to actinic radiation and rupturing the microcapsules in contact with an acid developer layer, such as a layer of acid clay, a visible image is obtained in the areas in which the ketone has been converted to the acid colorable form by irradiation. Phillips also discloses a self-contained system in which the acid developer is on the same support as the microcapsules containing the Michler's ketone.

Levy, U.S. Patent No. 4,149,887, relates to a microcapsule-containing imaging material having a photoconductive internal phase which is exposed in an RF field. Exposure increases the conductivity of the internal phase and causes the microcapsules to heat, swell and then rupture in the exposed areas thereby freeing the contents to form images. The microcapsules may contain color precursors which form images by reacting with a developing agent.

Japanese Kokai 34488/1977 to Nihon Denshin Denwa Kosha discloses an imaging material in which the microcapsule walls contain a photosensitive material which decomposes and generates a gas upon exposure to actinic radiation. Upon exposure, the capsules rupture and release their internal phase which contains an image-forming agent which reacts with a developer material and produces an image.

Japanese Kokai, 6212/1974 to Matsushita Denki Sangyo K.K., relates to a recording material in which microcapsules having a photocrosslinkable polymer wall contain a colorless or substantially colorless precursor in a polar solvent and, optionally, an acid dye developer. The polar solvent prevents the color precursor from reacting with the acid dye developer and forming a color image. Images are formed by image-wise exposing the material to actinic radiation and rupturing the microcapsules in the unexposed areas, whereupon the polar solvent evaporates and color development occurs.

Japanese Kokai, 9519 and 9520/1978 to K. K. Ricoh, relate to imaging systems in which the microcapsules contain a radiation curable internal phase including a dye precursor. Images are formed by image-wise exposing a layer of the microcapsules to light and selectively transferring the microcapsules from the unexposed areas to a receiving sheet. The microcapsules are not ruptured. Upon subsequent wet development processing of the transfer sheet with a dye developer, the dye precursor in the microcapsules is converted to a colored form and an image is obtained.

British Patent Nos. 1,058,798; 1,141,475; and 1,193,923 to DuPont relate to imaging materials which employ a photopolymerizable substratum comprising a solid binder having a polymerizable ethylenically unsaturated compound dispersed therein. Images are formed by image-wise exposing the materials to actinic radiation. Exposure controls the rate of diffusion of a developer material into or out of the photopolymerizable substratum.

British Patent No. 1,001,832 to DuPont discloses an imaging material in which a color former may be incorporated in a layer of a photopolymerizable, ethylenically unsaturated compound and an oxygen impermeable cover sheet is placed over the photopolymerizable layer during exposure to limit the concentration of atmospheric oxygen in contact with the photopolymerizable layer and thereby increase the speed and sensitivity of the photopolymerizable material.

Currently, the principal means used to develop photosensitive materials employing microencapsulated radiation sensitive compositions are devices which physically act on the microcapsules to rupture them such as nip rollers and burnishing devices. These devices are costly to manufacture and use, and require frequent maintenance. Thus, there is a need for a less expensive and more efficient means of developing these materials.

The term "microcapsule" is used herein to refer to both microcapsules having a discrete wall and microcapsules formed in an open phase system wherein discrete droplets of photoactive internal phase are dispersed in a binder. Thus, whenever reference is made to "microcapsules" or "encapsulation" in the specification and appended Claims, without reference to a discrete microcapsule wall, both types of microcapsules are intended.

The term "image areas" as used herein means the areas in which the internal phase is released from the microcapsules, regardless of whether the image formed is a positive or negative image.

The term "actinic radiation" is open to the entire electromagnetic spectrum and includes ultraviolet, infrared, visible, X-ray and to other radiation sources such as ion beam.

A principal objective of the present invention is to provide a more convenient means of developing photosensitive materials employing microencapsulated radiation sensitive compositions. As explained below, we have achieved this in that, following exposure the microcapsules are ruptured by uniformly heating the photosensitive material.

Capsules which will disintegrate when exposed to electromagnetic radiation are described in EB—A—1128513. Infra-red radiation is mentioned as one example of such disintegrating radiation. There is no suggestion of using such capsules in an imaging system of the kind with which the present invention is concerned, and the capsule specifically described in the said specification would not be useful for the present applicant's purposes.

As explained in our French Patent Specification 2516269 irradiation of photosensitive materials, which employ a microencapsulated radiation sensitive composition, causes a change in the viscosity of the internal phase of the microcapsules which prevents the microcapsules from rupturing or releasing their contents. By image-wise exposing an imaging sheet provided with a layer of photoactive microcapsules to actinic radiation and rupturing the microcapsules, the internal phase is released from the microcapsules in relation to the degree of exposure. If the microcapsules contain an image-forming agent, such as a visible dye or a colour former, the image-forming agent is released from the microcapsules and an image is formed upon transfer of the dye or upon reaction of the colour former with a developer material.

Thermally rupturable photoactive microcapsules are employed in the practice of the present invention. These microcapsules are prepared by incorporating a thermally decomposable compound in the internal phase of the capsules such that a gas is generated inside the capsules upon heating the imaging sheet. These heat activatable materials are suitably selected such that the capsules can be ruptured by heating the imaging sheet without substantially advancing the imaging photochemistry. If the imaging photochemistry is advanced by heating, image quality may suffer.

In accordance with a first aspect of the present invention, we provide an imaging sheet comprising: a support, and a layer of rupturable microcapsules on said support, said microcapsules containing an internal phase including a radiation sensitive composition which undergoes a change in viscosity upon exposure to actinic radiation, characterised in that said internal phase further includes a heat activatable material comprising a compound which decomposes upon heating to release a gas in quantity sufficient to rupture said microcapsules upon heating to a predetermined temperature, whereby said sheet is adapted to form images by image-wise exposing said imaging sheet to actinic radiation and heating said sheet, whereby said microcapsules rupture under gas pressure and image-wise release said internal phase.

An image-forming agent is usually associated on the imaging sheeting with the microcapsules, and the image-forming agent is mobilized or otherwise activated when the microcapsules are ruptured and the internal phase is released. One example of a suitable image-forming agent is a colour former; another example is an oil soluble dye; still another example is a chelate-forming cmpound. However, it is not necessary to use an image-forming agent with the sheet since the radiation sensitive composition itself can function in that capacity as described later herein.

In a second and alternative aspect of this invention, there is provided an imaging sheet comprising: a support, and a layer of rupturable microcapsules on said support, said microcapsules having discrete microcapsule walls and containing a radiation sensitive composition and a colour former in the internal phase, and said radiation sensitive composition including an ethylenically unsaturated compound and a photoinitiator such that said radiation sensitive composition undergoes an increase in viscosity upon exposure to actinic radiation, characterised in that said internal phase further includes a heat activatable material comprising a compound which decomposes upon heating to release a gas in quantity sufficient to rupture said microcapsules upon heating to a predetermined temperature, whereby said sheet is adapted to form images by image-wise exposing said imaging sheet to actinic radiation and heating said sheet whereupon said microcapsules rupture under gas pressure and image-wise release said internal phase.

The invention can be embodied in a self-contained imaging sheet wherein a developer material is incorporated in the imaging sheet such that when the microcapsules are ruptured, the image-forming agent reacts with the developer to produce an image.

According to a third alternative aspect of this invention, there is provided an imaging process which comprises the steps of: image-wise exposing an imaging sheet comprising a support having on one surface thereof a layer of rupturable microcapsules containing a radiation sensitive composition which undergoes a change in viscosity upon exposure to actinic radiation, and thereafter rupturing said microcapsules imagewise to release the internal phase of the microcapsules; the process being characterised in that, following said image-wise exposure step, said layer of microcapsules is heated to a temperature at which a heat activatable material contained in the internal phase of the microcapsules decomposes to release a gas in quantity sufficient to rupture said microcapsules and image-wise release said internal phase.

If images are formed by a transfer process, the exposed imaging sheet can be heated in contact with the image-receiving developer sheet or the sheet can be heated separately and thereafter assembled with the image receiving sheet for transfer.

The imaging sheets and processes in accordance with the present invention can employ various radiation sensitive materials and image-forming agents to produce images by a number of different mechanisms.

For example, positive working photohardenable or negative working photosoftenable radiation sensitive compositions can be used. Photohardenable compositions such as photopolymerizable and photocrosslinkable materials increase in viscosity or solidify upon exposure and yield positive images. Photosoftenable materials, such as some photodecomposable or photodepolymerizable materials, decrease in viscosity and result in negative images.

Ethylenically unsaturated organic compounds are useful radiation curable materials. These compounds contain at least one terminal ethylene group per molecule. Typically, they are liquid. Polyethylenically unsaturated compounds having two or more terminal ethylene groups per molecule are preferred. An example of this preferred subgroup are ethylenically unsaturated acid esters of polyhydric alcohols, such as trimethylol propane triacrylate (TMPTA).

Another suitable radiation sensitive composition is an acrylate prepolymer derived from the partial reaction of pentaerythritol with acrylic acid or acrylic acid esters. Photosensitive compositions based on these prepolymers having an acrylate functionality of between approximately two and three are available commercially in two-package systems from The Richardson Company, Melrose Park, Illinois, such as those sold under the trade designation "RL-1482" and "RL-1483". These are recommended to be mixed together to form a radiation curable clear varnish in a ratio of 4.4 parts of RL-1482 to one part RL-1483.

Another group of substances useful as radiation sensitive compositions include isocyanate modified acrylic, methacrylic and itaconic acid esters of polyhydric alcohols as disclosed in U.S. Patents Nos. 3,783,151; 3,759,809 and 3,825,479, all to Carlick et al. Radiation curable compositions including these isocyanate modified esters and reactive diluents such as tetraethylene glycol diacrylate as well as photoinitiators such as chlorinated resins, chlorinated paraffins and amine photoinitiation synergists are commercially available as over print varnishes from Sun Chemical Corp., Carlstat, New Jesey, under the trademark "Sun Cure" resins.

The radiation sensitive component of several radiation curable inks is also suitable for use in practice of this invention. An example of this type of material is a mixture of pentaerythritol acrylate and a halogenated aromatic, alicyclic or aliphatic photoinitiator, as disclosed in U.S. Patent No. 3,661,614 to Bessemir et al.

An example of radiation depolymerizable materials that may be useful in other embodiments of the invention are 3-oximino-2-butanone methacrylate which undergoes main chain scission upon U.V. exposure and poly 4'-alkyl acylophenones. See Reichmanis, E.; *Am. Chem. Soc. Div. Org. Coat. Plast. Chem. Prepr.* 1980. *43*, 243—251 and Lukac, I.; Chmela S., Int. Conf. on Modif. Polym. 5th. Bratislave, Czech. July 3—6, 1979, I.U.P.A.C. Oxford, England 1979, *1*, 176—182.

The radiation sensitive composition must make up a large enough proportion of the internal phase to effectively control the flow of the internal phase upon development. This generally means that the radiation sensitive material constitute approximately 40 to 99% by weight of the internal phase of the microcapsules.

In most cases, the radiation sensitive composition includes a photoinitiator. It is possible to use either photoinitiators which are converted to an active species by homolytic cleavage upon absorption of radiation or those which generate a radical by abstracting a hydrogen from a hydrogen donor. There may also be used photoinitiators which complex with the sensitizer to produce a free radical generating species or photoinitiators which otherwise generate radicals in the presence of a sensitizer. If the system relies upon ionic polymerization, the photoinitiator may be the anion or cation generating type, depending on the nature of the polymerization. It is important, however, that the photoinitiator be thermally inactive or at least not active at the temperatures required to rupture the capsules upon development.

Examples of photoinitiators useful in practice of the present invention include diaryl ketone derivatives, quinones and benzoin alkyl ethers. Where ultraviolet sensitivity is desired, suitable photoinitiators include alkoxy phenyl ketones, O-acylated oximinoketones, polycyclic quinones, phenanthrenequinone, naphthoquine, diisopropylphenanthrenequinone, benzophenones and substituted benzophenones, xanthones, thioxanthones, halogenated compounds such as chlorosulphonyl and chloromethyl polynuclear aromatic compounds, chlorosulphonyl and chloromethyl heterocyclic compounds, chlorosulphonyl and chloromethyl benzophenones and fluorenones, and haloalkanes.

In many cases it is advantageous to use a combination of imaging photoinitiators. For ultraviolet sensitivity one desirable combination is a combination of Michler's ketone and benzoin methyl ether (preferred ratio 2:5). Another useful combination is 2,2' - dimethoxy - 2 - phenylacetophenone, isopropylxanthone and ethyl para-dimethylaminobenzoate. The later is preferably used with TMPTA to provide a radiation sensitive composition.

Various image-forming agents can also be used. For example, images can be formed by the interaction of colour formers and colour developers of the type conventionally used in the carbonless paper art. In addition, images can be formed by the colour producing interaction of a chelating agent and a metal salt or by the reaction of certain oxidation-reduction reaction pairs, many of which have been investigated for use in pressure-sensitive carbonless papers. Alternatively, an oil soluble dye can be used as an image-forming agent and images can be formed by transfer of the dye to plain or treated paper. The internal phase itself has image-forming capability. For example, the toner used in xerographic recording processes selectively adheres to the image areas of an imaging sheet exposed and developed by a process in accordance with the present invention.

Furthermore, the image-forming agent can be provided inside the microcapsules, in the microcapsule wall, or outside the microcapsules in the same layer as the microcapsules or in a different layer. In the latter cases, the internal phase picks up the image-forming agent (e.g., by dissolution) upon being released from the microcapsules and carries it to the developer layer or an associated developer sheet.

Typical colour precursors useful in the aforesaid embodiments include colourless electron donating type compounds. Representative examples of such colour formers include substantially colourless compounds having in their partial skeleton a lactone, a lactam, a sultone, a spiropyran, an ester or an amido structure such as triarylmethane compounds, bisphenyl-methane compounds, xanthene compounds, fluorans, thiazine compounds, spiropyran compounds and the like. Crystal Violet Lactone and Copikem X, IV and XI (products of Hilton-Davis Co.) (Copikem is a trademark) may be used alone or in combination as colour precursors in practice of the present invention.

Illustrative examples of colour developers useful in conjunction with the embodiment employing the aforesaid colour precursors are clay minerals such as acid clay, active clay, and attapulgite; organic acids such as tannic acid, gallic acid, and propyl gallate; acid polymers such as phenol-formaldehyde resins, phenol acetylene condensation resins, and condensates between an organic carboxylic acid having at least one hydroxy group and formaldehyde; metal salts or aromatic carboxylic acids such as zinc salicylate, tin salicylate, zinc 2-hydroxy naphthoate, zinc 3,5 di-tert butyl salicylate, oil soluble metal salts or phenol-formaldehyde novolak resins (e.g., see U.S. Patent Nos. 3,672,935; 3,732,120 and 3,737,410) such as zinc modified oil soluble phenolformaldehyde resin as disclosed in U.S. Patent No. 3,732,120, zinc carbonate, and mixtures thereof.

The aforementioned colour formers and colour developers can be used interchangeably, that is the colour former can be encapsulated and the developer can be provided in a layer or vice versa.

An example of an image-forming salt-chelate pair is nickel nitrate and N,N'bis(2-octanoyloxy-ethyl)-dithiooxamide. It is preferable to encapsulate the chelating agent and use the salt in a developer layer.

Substantially any benign coloured dye can be used as an image-forming agent. A few examples are Sudan Blue and Rhodamine B dyes. The dyes are preferably oil soluble since the most easily employed encapsulation techniques are conducted using an aqueous continuous phase.

The most common substrate for use in the practice of this invention is paper. The paper may be a commercial impact raw stock, or special grade paper such as cast-coated paper or chrome-rolled paper. The latter two papers are preferred when using microcapsules having a diameter between approximately 1 and 5 μm, because the surface of these papers is smoother and therefore the microcapsules are not as easily embedded in the stock fibres. Transparent substrates such as polyethylene terephthalate and translucent substrates can also be used in practice of this invention.

Discrete walled microcapsules if used in practice of the present invention can be produced using known encapsulation techniques including coacervation, interfacial polymerization, or polymerization of one or more monomers in an oil. Representative examples of suitable wall-formers are gelatin materials (see U.S. patent Nos. 2,730,456 and 2,800,457 to Green et al) including gum arabic, polyvinyl alcohol, carboxymethylcellulose; resorcinol-formaldehyde wall formers (see U.S. patent No. 3,755,190 to Hart et al); isocyanate wall-formers (see U.S. Patent No. 3,914,511 to Vassiliades); isocyanate-polyol wall-formers (see U.S. Patent No. 3,796,669 to Kirin- tani et al.); urea formaldehyde wall-formers, particularly urea-resorcinol-formaldehyde in which oleophilicity is enhanced by the addition of resorcinol (see U.S. Patent Nos. 4,001,140; 4,087,376 and 4,089,802 to Foris et al.); and melamineformaldehyde resin and hydroxypropyl cellulose (see commonly assigned U.S. Patent No. 4,025,455 to Shackle). The material used to form the microcapsule walls must be selected for the radiation sensitive composition that is to be encapsulated such that it is substantially transparent to the exposure radiation. For the systems described above, urea-resorcinol-formaldehyde and gelatin microcapsules are generally preferred.

The mean microcapsule size used in practice of the present invention generally ranges from about 1 to 25 µm.

An open phase system may be used instead of discrete microcapsules. This can be done by dispersing what would otherwise be the internal phase throughout a binder as discrete droplets and coating the composition on the substrate. Suitable coatings for this embodiment include polymer binders whose viscosity has been adjusted to match the dispersion required in the coating. Suitable binders are gelatin, polyvinyl alcohol, polyacrylamide, and acrylic lattices.

The microcapsules are rendered thermally rupturable by incorporating in the internal phase a heat activatable agent. The preferred agents decompose by heating to a temperature generally in the range of 90 to 250°C. If the compound releases a gas at temperatures below ·40°C, the imaging sheet may be inadvertently developed upon exposure to ambient heat. Many photoinitiators can also be activated by heat. Hence, the gas generating agent must decompose at a temperature below the temperature at which the photoinitiator if present is heat-activated. These temperatures will vary with the particular photoinitiator system.

The heat activatable agent is incorporated in the internal phase of the microcapsules in an amount sufficient to generate sufficient gas to rupture the microcapsules upon heating. The amount will vary with the particular agent that is used. Some typical examples are shown below.

Compounds which generate a gas by decomposition upon exposure to heat are well known *per se*. Typical examples of useful thermally decomposable gas generating compounds include various blowing agents. Azo compounds such as azodicarbonamide, 1,3-diphenyltriazene, 1,3-bis(o-xenyl)-triazene, 2,2-azobisisobutyronitrile, 1,1'-azobiscyclohexanecarbonitrile, azobisisobutyramidoxime, and diarylpentazadienes are useful. In most cases it is necessary to incorporate these compounds in the internal phase in solid form since the gas generating agents are typically not soluble in an oil phase. Other compounds, potentially useful as gas generating agents are 4,4'-oxybis-(benzenesulphonyl hydrazide), N,N'-dimethyldinitrosoterephthalamide, dinitrosopentamethylenetetramine, ethylene carbonate,

guanidine nitrite, guanylurea nitrite, acetamidine nitrite, urea oxalate, 1,1'-dithio-diformamidine, diethylazodi-carboxylate, benzil monohydrazone, 4,4'-oxybis-(benzenesulphonyl hydrazide), 4,4'-oxybis-(benzenesulphonyl semicarbazide), p-t-butylbenzoyl azide, N,N'-dimethyl-N,N'-dinitroso-terephthalamide, quinone diazides, and other azo compounds.

As previously indicated, the imaging sheets can be made sensitive to ultraviolet, infrared, visible, X-ray and other types of actinic radiation. Depending upon the exposure source used, the nature of the exposing radiation, and the nature of the radiation sensitive composition, exposure alone may cause a sufficient change in the viscosity of the internal phase to control imaging. Otherwise, exposure can be used to initiate or advance the photochemistry in the exposed areas and the heat treatment can be used to complete the polymerization process and render the internal phase unreleasable upon heating.

Embodiments of imaging sheets in accordance with the invention can be exposed using a fairly simple exposure apparatus. In its simplest form for reflection imaging, the apparatus requires only a radiation source, means of focusing the exposure radiation from the original on to the imaging sheet, means to join the imaging sheet with the developer sheet (in the case of a transfer material), and means for heating at least the imaging sheet to rupture the microcapsules. The imaging sheet can be heated alone or in assembly with a developer sheet when a developer sheet is required. It is generally preferred to heat the sheet assembled with the developer sheet because heating also accelerates the reaction of the developer and the image forming agent.

Imaging sheets exposed in this way can be ruptured by passing the sheet through a pair of rollers, at least one of which is heated to a temperature sufficient to rupture the microcapsules. Alternatively, the imaging sheet can be placed in contact with a heated platen. It may also be possible to rupture the capsules by uniformly irradiating the surface of the imaging sheet with infrared radiation or by directing heated air against the surface of the imaging sheet.

The present invention is further illustrated by the following non-limiting example, in which "parts" and "percentages" are by weight unless otherwise expressed.

Example

A self-contained imaging sheet was prepared by coating the following compositions, in order, on a sheet of "80 pound Black and White Enamel Stock" ("Black and White" is a trademark of The Mead Corporation):

Developer coating composition

A mixture of 240 g 25% Tamol 731 (Rohm & Haas Co.) ("Tamol" is a trademark), 75 g dry HT clay, 1000 g SD-74 (trade designation) Resin (a synthetic developer manufactured by Fuji Photo Film Co., Ltd.), 15 g Calgon T (Calgon, Inc.) ("Calgon" is a trade mark) and 30 g Dequest 20006 (Monsanto Co.) ("Dequest" is a trademark) was ground to a particle size of less than 5 μm. 65 parts by weight of the ground mixture was added to 25 parts HT clay and 10 parts Dow 501 Latex (Dow Chemical Co.) ("Dow" is a trademark). This mixture was coated on the aforementioned enamel stock using a No. 10 Meyer rod in a coat weight of 2.27 kg per 306.58 m² (5 pounds per 3300 sq. ft.).

Microcapsule coating

A solution of 50 g TMPTA, 12 g Irgacure 651 (Ciba Geigy), 1 g Quantacure ITX (Blenkinsop & Co., Ltd.) 6 g of 50% Copikem X in dibutyl succinate (Hilton Davis Co.) and 2 g of azodicarbonamide, as the photoactive internal phase was prepared. "Irgacure", "Quantacure" and "Copikem" are each trademarks. This solution was microencapsulated as follows:

A mixture of 22.8 g 20% Isobam (trademark), 54.0 g water and 30.8 g 10% gum arabic was heated with stirring to 60°C and the pH was adjusted to 4.0 with the addition of 20% sulphuric acid. Thereafter 8.3 g urea and 0.8 g resorcinol were added and the solution was stirred at 60°C for 15 minutes to prepare a continuous phase. The continuous phase was placed in a Waring (Trademark) blender and the photoactive internal phase at 60°C was added with blending at 9 Variac (trademark) setting of 90 at 140 V for 30 seconds. Thereafter the speed of the blender was reduced to 40 and 21.4 ml of 37% formaldehyde was added. Blending was continued at that speed for 2 hours at 60°C. The emulsion was then transferred to a metal beaker and 0.6 g of ammonium sulphate in 12.2 g water was added. This emulsion was stirred with an overhead mixer at 60°C for another hour and the pH was adjusted to 9.0 using a 10% solution of sodium hydroxide. Finally, 2.8 g sodium bisulphite was dissolved in the mixture with stirring.

The microcapsule preparation was diluted 1:1 with water containing 1% Triton-X 100 (Rohm & Haas Co.) ("Triton" is a trademark) and coated on the developer layer to provide a coat weight of about 6 g/m².

The self-contained imaging sheet prepared as above was exposed through a step wedge for 16 seconds in a ultraviolet sensitometer. Thereafter the imaging sheet was taped, coated side up, to a glass microscope slide and placed on a temperature gradient melting point apparatus (185—230°C) manufactured by Parr Instrument Co. and heated. The step wedge image appeared in 15 seconds. The imaging sheet provided D max=0.95 and D min=0.46. In this example a temperature gradient heating device was used in order to determine the relationship between image density and development temperature. In commercial practice a uniform development temperature would be used.

Reference Example

For reference, an imaging sheet prepared and exposed identical to the imaging sheet in Example 1 was developed by passing the sheet through pressure rollers. This sheet provided D max=1.00 and D min=0.20. A control sheet was prepared as in Example 1 without the heat activatable material and was exposed and developed as in Example 1. A low density negative image was obtained.

## Claims

1. An imaging sheet comprising: a support, and a layer of rupturable microcapsules on said support, said microcapsules containing an internal phase including a radiation sensitive composition which undergoes a change in viscosity upon exposure to actinic radiation, characterised in that said internal phase further includes a heat activatable material comprising a compound which decomposes upon heating to release a gas in quantity sufficient to rupture said microcapsules upon heating to a predetermined temperature, whereby said sheet is adapted to form images by image-wise exposing said imaging sheet to actinic radiation and heating said sheet, whereby said microcapsules rupture under gas pressure and image-wise release said internal phase.

2. An imaging sheet according to Claim 1, further characterised in that said radiation sensitive composition is a photohardenable or photosoftenable composition.

3. An imaging sheet according to Claim 2, further characterised in that said radiation sensitive composition includes an ethylenically unsaturated compound and a photoinitiator.

4. An imaging sheet according to any preceding Claim, further characterised in that said heat activatable material decomposes at a temperature in the range of 90 to 250°C.

5. An imaging sheet according to any preceding Claim, further characterised in that said heat activatable material is an azo compound.

6. An imaging sheet according to any preceding Claim, further characterised in that said microcapsules have discrete walls.

7. An imaging sheet according to Claim 6, further characterised in that an image-forming agent is associated with said microcapsule such that upon rupturing said microcapsules and releasing said internal phase, said image-forming agent is image-wise mobilized.

8. An imaging sheet comprising: a support, and a layer of rupturable microcapsules on said support, said microcapsules having discrete microcapsule walls and containing a radiation sensitive composition and a colour former in the internal phase, and said radiation sensitive composition including an ethylenically unsaturated compound and a photoinitiator such that said radiation sensitive composition undergoes an increase in viscosity upon exposure to actinic radiation, characterised in that said internal phase further includes a heat activatable material comprising a compound which decomposes upon heating to release a gas in quantity sufficient to rupture said microcapsules upon heating to a predetermined temperature, whereby said sheet is adapted to form images by image-wise exposing said imaging sheet to actinic radiation and heating said sheet whereupon said microcapsules rupture under gas pressure and image-wise release said internal phase.

9. An imaging sheet according to Claim 8, further characterised in that said heat activatable material decomposes at a temperature in the range of 90 to 250°C.

10. An imaging sheet according to Claims 8 or 9, further characterised in that said heat activatable material is an azo compound.

11. An imaging sheet according to Claims 8, 9 or 10, further characterised in that said sheet further comprises a layer of a developer material interposed between said support and said layer of microcapsules so as to provide a self-contained imaging sheet.

12. Transfer imaging means comprising an imaging sheet according to Claims 8, 9 or 10 and developer material provided on a support separate and distinct from said support carrying said microcapsules so as to provide in combination with said imaging sheet a transfer imaging system.

13. An imaging process which comprises the steps of: image-wise exposing an imaging sheet comprising a support having on one surface thereof a layer of rupturable microcapsules containing a radiation sensitive composition which undergoes a change in viscosity upon exposure to actinic radiation, and thereafter rupturing said microcapsules image-wise to release the internal phase of the microcapsules; the process being characterised in that, following said image-wise exposure step, said layer of microcapsules is heated to a temperature at which a heat activatable material contained in the internal phase of the microcapsules decomposes to release a gas in quantity sufficient to rupture said microcapsules and image-wise release said internal phase.

14. A process according to Claim 13, further characterised in that said layer of microcapsules is heated to a temperature in the range of 90 to 250°C.

**Patentansprüche**

1. Bilderstellungs-Blatt, das aus einem Stützblatt und einer auf der Oberfläche des Stützblattes befindlichen Schicht aufbrechbarer Mikrokapseln besteht, die eine interne Phase enthalten, umfassend eine strahlungsempfindliche Verbindung, die bei Belichtung mit fotoaktiver Strahlung ihre Viskosität ändert, dadurch gekennzeichnet, daß die genannte interne Phase weiterhin ein durch Wärme aktivierbares Material enthält, das aus einer Verbindung besteht, die bei Erwärmung sich zersetzt und bei Erwärmung auf eine bestimmte Temperatur ein Gas in einer solchen Menge freisetzt, daß es die genannten Mikrokapseln zum Platzen oder Aufbrechen bringt, wobei das genannte Blatt geeignet ist durch eine bildentsprechende Belichtung des genannten Bilderstellungs-Blatts mit fotoaktiver Strahlung und Erwärmung des genannten Blatts Bilder zu erstellen, wobei die genannten Mikrokapseln unter Gasdruck aufbrechen oder zerplatzen und die genannte interne Phase bildentsprechend freisetzen.

2. Bilderstellungs-Blatt nach Anspruch 1, dadurch gekennzeichnet, daß die strahlungsempfindliche Verbindung eine lichthärtende oder lichterweichende Verbindung ist.

3. Bilderstellungs-Blatt nach Anspruch 2, dadurch gekennzeichnet, daß die genannte strahlungsempfindliche Verbindung eine ethylenische ungesättigte Verbindung sowie einen Fotoinitiator enthält.

4. Bilderstellungs-Blatt nach einem vorherigen Ansprüche, dadurch gekennzeichnet, daß das genannte durch Wärme aktivierbare Material sich bei einer Temperatur im Bereich zwischen 90° und 250° Celsius zersetzt.

5. Bilderstellungs-Blatt nach einem der vorherigen Ansprüche, dadurch gekennzeichnet, daß das genannte durch Wärme aktivierbare Material eine Azoverbindung ist.

6. Bilderstellungs-Blatt nach einem der vorherigen Ansprüche, dadurch gekennzeichnet, daß die Mikrokapseln diskrete Kapselwände besitzen.

7. Bilderstellungs-Blatt nach Anspruch 6, dadurch gekennzeichnet, daß ein bilderstellendes Agens so mit der genannten Mikrokapsel verbunden ist, daß beim Aufbrechen oder Zerplatzen des genannten Mikrokapseln und der Freisetzung der genannten internen Phase das genannte bilderstellende Agens bildentsprechend mobilisiert wird.

8. Bilderstellungs-Blatt, das aus einem Stützblatt und einer auf der Oberfläche des Stützblattes befindlichen Schicht aufbrechbarer Mikrokapseln besteht, die diskrete Kapselwände besitzen und in der internen Phase ein strahlungsempfindliches Präparat sowie einen Farbbildner enthalten und die genannte strahlungsempfindliche Verbindung eine ethylenische ungesättigte Verbindung sowie einen Fotoinitiator enthält, so daß die strahlungsempfindliche Verbindung bei einer Belichtung mit fotoaktiver Strahlung ihre Viskosität erhöht, dadurch gekennzeichnet, daß die genannte interne Phase eine Verbindung umfaßt, die bei Erwärmung sich zersetzt, und bei Erwärmung auf eine bestimmte Temperatur ein Gas in einer solchen Menge freisetzt, daß es die genannten Mikrokapseln zum Platzen oder Aufbrechen bringt, wobei das gennante Blatt geeignet ist, durch eine bildentsprechende Belichtung des genannten Bilderstellungs-Blattes mit fotoaktiver Strahlung und Erwärmung des genannten Blattes Bilder zu erzeugen, wobei die genannten Mikrokapseln unter Gasdruck aufbrechen oder zerplatzen und die genannte interne Phase bildentsprechend freisetzen.

9. Bilderstellungs-Blatt nach Anspruch 8, dadurch gekennzeichnet, daß das durch Wärme aktivierbare Material sich bei einer Temperatur im Bereich zwischen 90° und 250°C zersetzt.

10. Bilderstellungs-Blatt nach Anspruch 8 oder 9, dadurch gekennzeichnet, daß das durch Wärme aktivierbare Material eine Azoverbindung ist.

11. Bilderstellungs-Blatt nach Anspruch 8, 9 oder 10, dadurch gekennzeichnet, daß das gennante Blatt weiterhin eine Entwickler-Schicht umfaßt, die so zwischen das genannte Stützblatt und die genannte Schicht von Mikrokapseln gelegt ist, so daß sich ein in sich geschlossenes, vollständiges Aufzeichnungs- und Bilderstellungsblatt bildet.

12. Bild-Transfer-System, umfassend eine Bilderstellungs-Blatt nach Ansprüchen 8, 9 oder 10 sowie ein Entwicklermaterial, das auch auf einem Stützblatt liegt, das von dem genannten, die Mikrokapseln tragenden Stützblatt getrennt und gesondert ist, so daß in Verbindung mit dem genannten Bilderstellungsblatt ein Bild-Transfer-System zur Verfügung steht.

13. Verfahren zur Bilderstellung, das aus den folgenden Schritten besteht:

bildentsprechende Belichtung eines Bilderstellungs-Blatts, das aus einem Stützblatt besteht, das auf seiner einen Oberfläche eine Schicht aufbrechbarer Mikrokapseln besitzt, die eine strahlungsempfindliche Verbindung enthalten, die bei Belichtung mit fotoaktiver Strahlung eine Viskositätsänderung durchmacht,

danach bildentsprechendes Aufbrechen der genannten Mikrokapseln, um die interne Phase der Mikrokapseln freizusetzen,

dadurch gekennzeichnet, daß nach dem Schritt der bildentsprechenden Belichtung die genannte Schicht von Mikrokapseln auf eine Temperatur erärmt wird, bei der ein in der internen Phase der Mikrokapseln enthaltenes, wärmeaktivierbares Material sich zersetzt und ein Gas in ausreichender Menge freisetzt, um die genannten Mikrokapseln zum Aufbrechen oder Zerplatzen zu bringen und bildentsprechend die genannte interne Phase freizusetzen.

14. Verfahren nach Anspruch 13, dadurch gekennzeichnet, daß die genannte Mikrokapsel-Schicht auf eine Temperatur im Bereich zwischen 90° und 250°C erwärmt wird.

**Revendications**

1. Feuille pour former des images comprenant: un support et une couche de microcapsules brisables sur ledit support, lesdites microcapsules contenant une phase interne comportant une composition sensible aux rayonnements, qui subit un changement de viscosité sous-exposition à un rayonnement actinique, caractérisée en ce que ladite phase interne comporte en outre une matière thermo-activable comprenant un composé qui se décompose à la chaleur pour libérer un gaz en quantité suffisante pour briser lesdites microcapsules sous l'effet d'un chauffage à une température prédéterminée, grâce à quoi ladite feuille est adaptée pour former des images par exposition suivant une image de ladite feuille à un rayonnement actinique et chauffage de ladite feuille, grâce à quoi lesdites microcapsules se brisent sous la pression du gaz et, suivant une image, libérent ladite phase interne.

2. Feuille pour former des images, selon la revendication 1, caractérisée en outre en ce que ladite composition sensible aux rayonnements est une composition photodurcissable ou photoramollissable.

3. Feuille pour former des images, selon la revendication 2, caractérisée en outre en ce que ladite composition sensible aux rayonnements contient un composé insaturé éthylénique et un photo-initiateur.

4. Feuille pour former des images, selon l'une quelconque des revendications précédentes, caractérisée en outre en ce que ladite matière thermo-activable se décompose à une température entre 90°C et 250°C.

5. Feuille pour former des images, selon l'une quelconque des revendications précédentes, caractérisée en outre en ce que ladite matière thermo-activable est un composé azo.

6. Feuille pour former des images, selon l'une quelconque des revendications précédentes, caractérisée en outre en ce que lesdites microcapsules ont des parois distinctes.

7. Feuille pour former des images, selon la revendication 6, caractérisée en outre en ce qu'un agent formateur d'images est associé à ladite microcapsule, de sorte qu'à la rupture des microcapsules et à la libération de ladite phase interne, ledit agent formateur d'image est mobilisé suivant une image.

8. Feuille pour former des images comprenant: un support et une couche de microcapsules brisables sur ledit support, lesdites microcapsules ayant des parois de microcapsules distinctes et contenant une composition sensible aux rayonnements et un formateur de couleurs dans la phase interne et ladite composition sensible aux rayonnements contenant un composé insaturé éthylénique et un photo-initiateur tel que ladite composition sensible au rayonnement subit une augmentation de viscosité par exposition à un rayonnement actinique, caractérisée en ce que la phase interne comprend en outre une matière thermo-activable comportant un composé qui se décompose à la chaleur pour libérer un gaz en quantité suffisante pour rompre lesdites microcapsules par chauffage à une température prédéterminée, grâce à quoi ladite feuille est adaptée pour former des images par exposition suivant une image de ladite feuille à un rayonnement actinique et chauffage de ladite feuille après quoi lesdites microcapsules se rompent sous la pression du gaz et libèrent suivant une image ladite phase interne.

9. Feuille pour former des images, selon la revendication 8, caractérisée en outre en ce que ladite matière thermoactivable se décompose à une température entre 90° et 250°C.

10. Feuille pour former des images, selon les revendications 8 ou 9, caractérisée en outre en ce que ladite matière thermo-activable est un composé azo.

11. Feuille pour former des images, selon les revendications 8, 9 ou 10, caractérisée en outre en ce que ladite feuille comprend en outre une couche d'une matière révélatrice interposée entre ledit support et ladite couche de microcapsules, de façon à fournir une feuille autonome pour former des images.

12. Moyens de transfer d'image comprenant une feuille pour former des images, selon les revendications 8, 9 ou 10, et une matière révélatrice prévue sur un support séparé et distinct dudit support portant lesdites microcapsules, de façon à fournir, en combinaison avec ladite feuille pour former des images, un système de transfert d'images.

13. Procédé de formation d'image, comprenant les étapes suivantes:

exposition suivant une image d'une feuille pour former des images, comprenant un support ayant sur une face une couche de microcapsules brisables contenant une composition sensible aux rayonnements, qui subit un changement de viscosité lors de l'exposition à un rayonnement actinique, et

ensuite rupture desdites microcapsules suivant une image pour libérer la phase interne des microcapsules;

ledit procédé étant caractérisé en ce que, après cette étape d'exposition suivant une image, ladite couche de microcapsule est chauffée à une température à laquelle une matière thermo-activable contenue dans la phase interne des microcapsules se décompose pour libérer un gaz en quantité suffisante pour rompre lesdites microcapsules et libérer suivant une image ladite phase interne.

14. Procédé selon la revendication 13, caractérisé en outre en ce que ladite couche de microcapsules est chauffée à une température entre 90°C et 250°C.